# EUROPEAN PATENT APPLICATION

(11) **EP 3 229 263 A1**
(43) Date of publication of application: **11.10.2017**
(21) Application number: 17163841.4
(22) Date of filing: 30.03.2017
(51) Int. Cl.: H01L 21/3065, H01L 29/66

(54) **SEMICONDUCTOR DEVICE AND FABRICATION METHOD THEREOF**

(30) Priority: 08.04.2016 CN 201610216931
(71) Applicant: Semiconductor Manufacturing International Corporation (Shanghai), Shanghai 201203 (CN); Semiconductor Manufacturing International Corporation (Beijing), Beijing 100176 (CN)
(72) Inventor: ZHANG, Chenglong, Shanghai, 201203 (CN); YUAN, Guangjie, Shanghai, 201203 (CN); ZHANG, Haiyang, Shanghai, 201203 (CN)
(74) Representative: Klunker IP Patentanwälte PartG mbB

(57) **Abstract**

A semiconductor device and fabrication method thereof are provided. The method includes forming at least one dummy gate structure and sidewall spacers of the dummy gate structure in a first dielectric layer, together on a substrate, and removing the dummy gate structure, thereby forming a first opening between the sidewall spacers. The method further includes forming a gate structure in the first opening and having a top surface levelled the first dielectric layer, removing a portion of the sidewall spacers and a portion of the gate structure, respectively, to form a second opening in the first dielectric layer, on remaining sidewall spacers, and on remaining gate structure, and forming a capping layer to fill the second opening and to have a top surface levelled with the first dielectric layer.

## Description

### CROSS-REFERENCES TO RELATED APPLICATIONS

This application claims the priority of Chinese patent application No. 201610216931.4, filed on April 8,2016.

### FIELD OF THE DISCLOSURE

The present invention generally relates to the field of semiconductor manufacturing technology and, more particularly, relates to a semiconductor device and fabrication method thereof.

### BACKGROUND

In semiconductor devices, multilayer circuits may be formed on a silicon wafer and may often be electrically connected via a contact structure. When fabricating the contact structure, first, an interlayer dielectric (ILD) layer is etched to form trenches or through-holes (also named openings). Then, an electrically conductive material is used to fill the trenches or through-holes to form the contact structure. With the rapid development of very-large-scale integration (VLSI) circuits, critical dimensions of circuit components continuously decrease, thus demanding higher requirements of the photolithographic process.

In semiconductor manufacturing processes, a self-alignment contact (SAC) technique is often applied to form contact structures. The SAC technique attracts wide attention because it lowers the requirement of photolithographic precision, and further reduces the area needed to form transistors.

However, when utilizing the SAC technique to form a contact structure on a source electrode or a drain electrode, the contact structure may easily touch a gate electrode, thus forming a short circuit that influences the performance of the semiconductor device. Accordingly, it is desirable to avoid the short circuit formed between the contact structure and the gate electrode in semiconductor devices.

### BRIEF SUMMARY OF THE DISCLOSURE

It is an object of the present invention to provide a semiconductor device and fabrication method which at least partially solve one or more problems set forth above and other problems.

The object is achieved by the features of the respective independent claims. Further embodiments are defined in the respective dependent claims.

A first aspect of the present invention provides a method for fabricating a semiconductor device. The method includes forming at least one dummy gate structure and sidewall spacers of the dummy gate structure in a first dielectric layer, together on a substrate and removing the dummy gate structure, thereby forming a first opening between the sidewall spacers. The method further includes forming a gate structure in the first opening and having a top surface levelled with a top surface of the first dielectric layer, removing a portion of the sidewall spacers and a portion of the gate structure, respectively, to form a second opening in the first dielectric layer, on remaining sidewall spacers, and on remaining gate structure, and forming a capping layer to fill the second opening and to have a top surface levelled with the top surface of the first dielectric layer.

Preferably, the dummy gate structure, the sidewall spacers, and the first dielectric layer have a coplanar top surface.

Preferably, a thickness of a removed portion of the sidewall spacers is greater than a thickness of a removed portion of the gate structure.

Preferably, a thickness of a removed portion of the sidewall spacers is less than or equal to a thickness of a removed portion of the gate structure.

Preferably, a thickness of a removed portion of the sidewall spacers ranges from 100 Å to 1000 Å.

Preferably, a thickness of a removed portion of the gate structure ranges from 100 Å to 1000 Å.

Preferably, the portion of the sidewall spacers is removed before or after the portion of the gate structure is removed.

Preferably, removing the portion of the sidewall spacers includes a dry etching process. Preferably, an etching gas for the dry etching process includes one or more gases selected from CF₃I, O₂, and H₂.

Preferably, forming the gate structure in the first opening comprises: forming a gate dielectric layer on a surface of the substrate and on the sidewall spacers of the first opening; and forming a gate electrode layer over the gate dielectric layer to fill the first opening.

Preferably, removing the portion of the gate structure comprises: using a dry or wet etching process to remove a portion of the gate dielectric layer; and using the dry etching process to remove a portion of the gate electrode layer.

Preferably, the capping layer is made of one or more materials selected from silicon nitride, titanium nitride, silicon carbide, silicon oxynitride, and carbon-doped silicon oxynitride.

Preferably, the sidewall spacers is made of one or more materials selected from silicon nitride, silicon oxynitride, and carbon-doped silicon oxynitride.

Preferably, the method further comprises: forming source/drain regions on sides of the dummy gate electrode in the substrate; and after forming the capping layer, forming contact structures in the first dielectric layer to electrically connect to the source/drain regions.

Preferably, the contact structures are formed by: forming a second dielectric layer on the first dielectric layer and the capping layer; forming a third opening in the second dielectric layer and the first dielectric layer to expose the source/drain regions; filling the third opening with an electrically conductive material; and planarizing the electrically conductive material to form the contact structures.

A second aspect of the present invention provides a semiconductor device. The semiconductor device includes a substrate, a plurality of gate structures and sidewall spacers of each gate structure, a first dielectric layer, a capping layer, source/drain regions, a second dielectric layer and contact structures. The plurality of gate structures and sidewall spacers of each gate structure are disposed in the first dielectric layer, together on the substrate. The capping layer is disposed on each gate structure and the sidewall spacers, and has a top surface levelled with a top surface of the first dielectric layer. The source/drain regions are on sides of the gate structures in the substrate. The second dielectric layer is disposed on the first dielectric layer and the capping layer. The contact structures are formed on the source/drain regions and each has a surface in contact with adjacent sidewall spacers, the capping layer, and the second dielectric layer.

Preferably, a top surface of the sidewall spacers are higher than a top surface of the plurality of gate structures.

Preferably, a top surface of the sidewall spacers are lower than or level with a top surface of the plurality of gate structures.

Preferably, a height of the sidewall spacers is approximately 50%∼90% of a height of the first dielectric layer.

Preferably, a height of the plurality of gate structures is approximately 50%∼80% of the height of the first dielectric layer.

Preferably, the capping layer is made of one or more materials selected from silicon nitride, titanium nitride, silicon carbide, silicon oxynitride, and carbon-doped silicon oxynitride.

Preferably, the sidewall spacers is made of one or more materials selected from silicon nitride, silicon oxynitride, and carbon-doped silicon oxynitride.

A semiconductor device according to the second aspect of the present invention is obtainable by a method for fabricating a semiconductor device according to the first aspect of the present invention.

Other aspects of the present invention can be understood by those skilled in the art in light of the description, the claims, and the drawings of the present invention.

### BRIEF DESCRIPTION OF THE DRAWINGS

FIGs 1∼9 illustrate intermediate structures corresponding to certain stages of an exemplary fabrication process of a semiconductor device consistent with the disclosed embodiments;
FIG. 10 illustrates an intermediate structure corresponding to certain stages of another exemplary fabrication process of a semiconductor device consistent with the disclosed embodiments; and
FIG. 11 illustrates a flow chart of an exemplary fabrication process of a semiconductor device consistent with the disclosed embodiments.

### DETAILED DESCRIPTION

Reference will now be made in detail to exemplary embodiments of the disclosure, which are illustrated in the accompanying drawings. Wherever possible, the same reference numbers will be used throughout the drawings to refer to the same or like parts.

The present invention provides a semiconductor device and fabrication method thereof. The disclosed device and method may effectively solve the short circuit issues and thus to improve performance of the fabricated semiconductor device. According to the present invention, a gate structure is formed in the first opening between the sidewall spacers, and a portion of the sidewall spacers and a portion of the gate structures are removed after the gate structure is formed. Thus, the fabrication of the semiconductor device may be simplified and the whole process may be completed in a gate electrode etching machine.

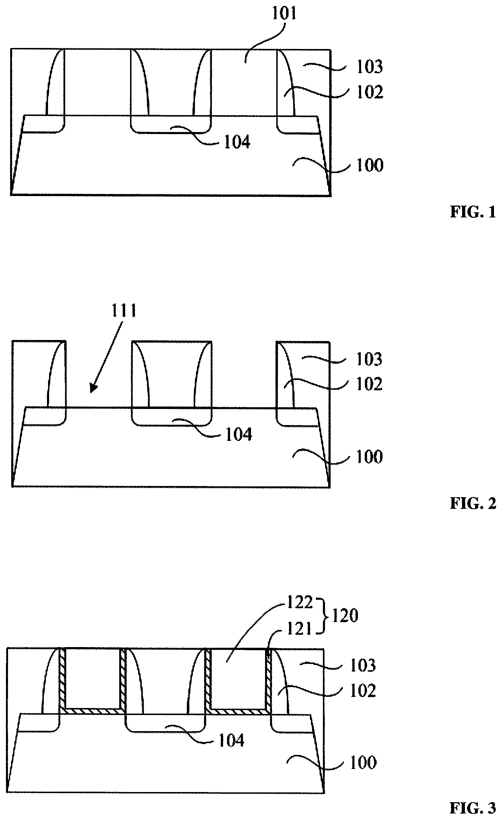

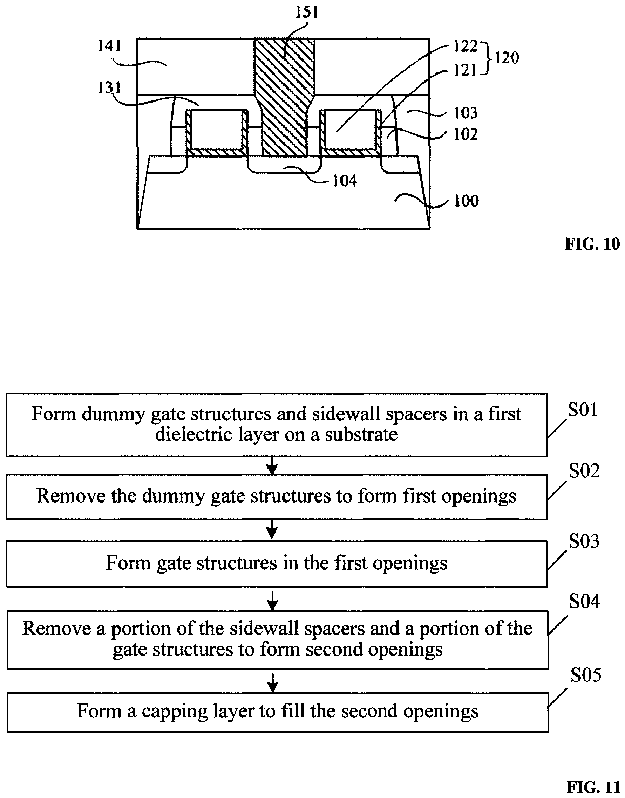

FIGs 1∼9 illustrate intermediate structures corresponding to certain stages of an exemplary fabrication process of a semiconductor device consistent with the disclosed embodiments. FIG. 11 illustrates a flow chart of an exemplary fabrication process of a semiconductor device consistent with the disclosed embodiments.

In step 1 (S01) of FIG. 11 and referring to FIG. 1, a substrate 100 is provided, and dummy gate structures 101, a first dielectric layer 103, and sidewall spacers 102 on two sides of each dummy gate structure 101 may be disposed on a surface of the substrate 100. For example, the dummy gate structures 101 and the sidewall spacers 102 may be disposed in the first dielectric layer 103, and may level with the top surface of the first electric layer 103. Source/drain regions 104 may be formed in the substrate 100 on two sides of the dummy gate structures 101.

The substrate 100 may be a semiconductor substrate, such as a single-crystalline silicon substrate, a single-crystalline germanium substrate, a silicon germanium substrate, a silicon carbide substrate, a silicon-on-insulator substrate, or a germanium-on-insulator substrate. The substrate 100 may also be a semiconductor substrate or fins formed on the semiconductor substrate. In one embodiment, the substrate 100 may be a fin formed on the semiconductor substrate.

The sidewall spacers 102 may be made of a material selected from silicon nitride, silicon oxynitride, and carbon-doped silicon oxynitride, or any combination thereof. In one embodiment, the sidewall spacers 102 may be made of silicon nitride.

The first dielectric layer 103 may be used to define the shape and locations of the to-be-formed gate structures, and the material of the first dielectric layer 103 may be silicon oxide, silicon nitride, silicon oxynitride, a low-K dielectric material (the dielectric constant greater than or equal to 2.5, but smaller than 3.9) or an ultra low-K dielectric material (the dielectric constant smaller than 2.5). In one embodiment, the material of the dielectric layer 103 may be silicon oxide.

In step 2 (S02) of FIG. 11 and referring to FIG. 2, the dummy gate structures 101 may be removed, and first openings 111 may be formed between the sidewall spacers 102. The method to remove the dummy gate structures 101 may be a dry-etching process. The dry-etching process may be an anisotropic dry-etching process or an isotropous dry-etching process. Optionally, the method that removes the dummy gate structures 101 may be a wet-etching process. In one embodiment, the material of the dummy gate structures 101 may be polycrystalline silicon, and the method to remove the dummy gate structures 101 may be the isotropic dry-etching process.

In step 3 (S03) of FIG. 11 and referring to FIG. 3, a gate structure 120 may be formed in each first opening 111 (as shown in FIG. 2), and the top surface of the gate structures 120 may level with the top surface of the first dielectric layer 103. Forming the gate structures 120 may include sequentially forming a gate dielectric layer 121 and a gate electrode layer 122 in the first openings 111. In one embodiment, the gate dielectric layer 121 may have a relatively small thickness and cover a part of the substrate 100 exposed by the first openings 111 and partial surface of the sidewall spacers 102. The gate electrode layer 122 may be disposed over the gate dielectric layer 121 and fill each first opening 111.

The material of the gate dielectric layer 121 may be a high-K dielectric material (the dielectric constant larger than 3.9). The high-K dielectric material may include hafnium oxide, zirconium oxide, hafnium zirconium oxide, lanthanum oxide, zirconium silicon oxide, titanium oxide, tantalum oxide, barium strontium titanium oxide, barium titanium oxide, strontium titanium oxide, and aluminium oxide. In one embodiment, the material of the gate dielectric layer 121 may be hafnium oxide.

The material of the gate electrode layer 122 may be Cu, W, Al, Au, or Ag. In one embodiment, the material of the gate electrode layer 122 may be W. In some other embodiments, before the gate electrode layer 122 is formed, an insulation layer may be formed over surface of the gate dielectric layer 121, and a work function layer may be formed over surface of the insulation layer. The material of the work function layer may be a metal or a metallic compound.

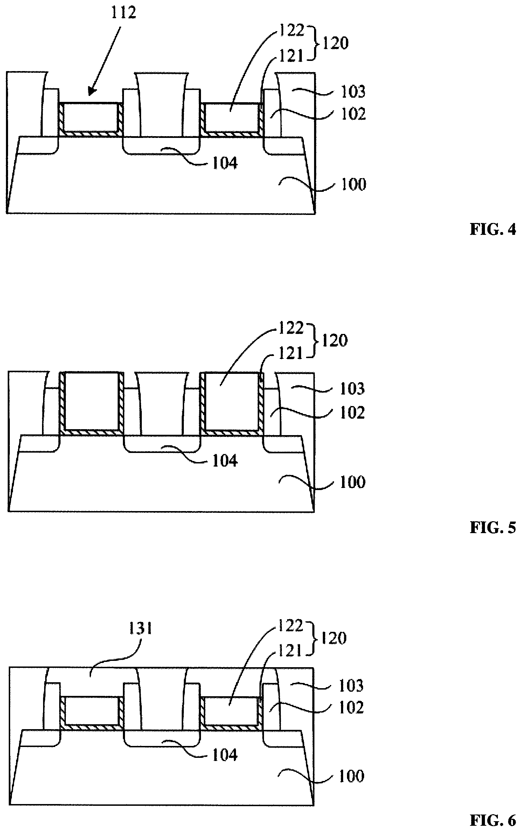

In step 4 (S04) of FIG. 11 and referring to FIG. 4, a portion of each sidewall spacer 102 and a portion of each gate structure 120 may be removed, respectively. Thus, the top surface of the remaining sidewall spacers 102 and the top surface of the remaining gate structures 120 may be lower than the top surface of the first dielectric layer 103. Accordingly, second openings 112 may be formed in the first dielectric layer 103. The portion of the sidewall spacers 102 may be removed before or after the portion of the gate structures 120 are removed.

In one embodiment, the portion of the sidewall spacers 102 may be removed first (as shown in FIG. 5), and the portion of the gate structures 120 may later be removed (as shown in FIG. 4). In some other embodiments, the portion of the gate structures 120 may be removed first, and the portion of the sidewall spacers 102 may later be removed.

In some embodiments, the thickness of the removed portion of the sidewall spacers 102 may be greater than the thickness of the removed portion of the gate structures 120. In some other embodiments, the thickness of the removed portion of the sidewall spacers 102 may be smaller than or equal to the thickness of the removed portion of the gate structures 120. The thickness of the removed portion of the sidewall spacers 102 may range from 100 Å to 1000 Å, and the thickness of the removed portion of the gate structures 120 may range from 100 Å to 1000 Å.

In one embodiment, the thickness of the removed portion of the sidewall spacers 102 may be 200 Å, and the thickness of the removed portion of the gate structures 120 may be 500 Å. That is, the thickness of the removed portion of the sidewall spacers 102 may be smaller than the thickness of the removed portion of the gate structures 120, and the top surface of the remaining sidewall spacers 102 may be above the top surface of the remaining gate structures 120.

The method to remove the portion of the sidewall spacers 102 may include a dry-etching process, and the dry-etching process may be an etching process with a high selectivity. That is, the rate to etch the sidewall spacers 102 may be higher than the rates to etch the first dielectric layer 103 and the gate structures 120. An etching gas for the dry-etching process may be a gas selected from CF₃I, O₂, and H₂, or any combination thereof. A flow rate of the etching gas may range from 10 mL/min to 2,000 mL/min, a pressure may range from 3 mtorr to 500 mtorr, and an etching power may range from 100 W to 3,000 W. In one embodiment, the etching gas used in the dry-etching process may be CF₃I, the flow rate of the gas CF₃I may be 500 mL/min, the pressure may be 100 mtorr, and the etching power may be 800 W.

Removing a portion of the gate structures 120 may include removing a portion of the gate dielectric layer 121 and removing a portion of the gate electrode layer 122. In one embodiment. The thickness of the removed portion of the gate dielectric layer 121 may be the same as the thickness of the removed portion of the gate electrode layer 122. The process to remove a portion of the gate structure 120 may include removing a portion of the gate dielectric layer 121 via a dry or wet etching process, and removing a portion of the gate electrode layer 122 via the dry-etching process.

In step 5 (S05) of FIG. 11 and referring to FIG. 6, a capping layer 131 may be formed to substantially fill the second openings 112 (as illustrated in FIG. 4) and level with the top surface of the first dielectric layer 103. A method to form the capping layer 131 may include forming the capping layer 131 to fill the second openings 112, and planarizing the capping layer 131, such that the top surface of the capping layer 131 may level with the top surface of the first dielectric layer 103.

A method to planarize the capping layer 131 may include chemical mechanical polishing, dry-etching, and wet-etching, or any combination thereof. In one embodiment, a plasma etching process may be applied to planarize the capping layer 131. Further, the material of the capping layer 131 may include silicon nitride, titanium nitride, silicon carbide, silicon oxynitride, carbon-doped silicon oxynitride, silicon oxide, and/or aluminium oxide. In one embodiment, the material of the capping layer 131 may be silicon nitride.

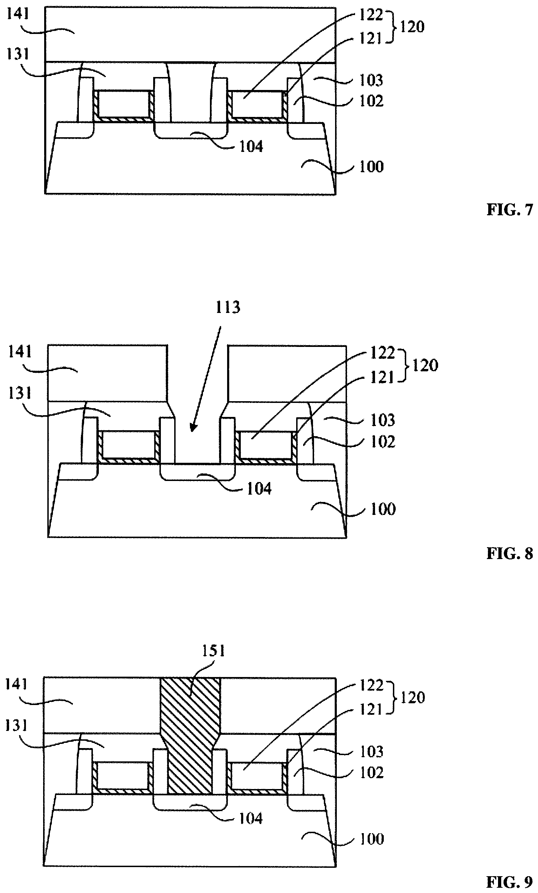

After forming the capping layer 131, contact structures 151 (e.g., as shown in FIG. 9) that are electrically connected to source/drain regions 104 may be formed in the first dielectric layer 103. In one embodiment, a method to form the contact structures 151 may include a self-alignment contact (SAC) technique.

FIG. 7∼FIG. 9 illustrate a method to form the contact structures 151. Referring to FIG.7, a second dielectric layer 141 may be formed on surface of the first dielectric layer 103 and the capping layer 131. A patterned photo-resist layer (not shown) may be disposed on the second dielectric layer 141, and the patterned photo-resist layer may be exposed to provide a region to form the contact structure 151. Referring to FIG. 8, the patterned photo-resist layer may be used as a mask to etch the second dielectric layer 141 and the first dielectric layer 103. A third opening 113 may be formed in the second dielectric layer 141 and the first dielectric layer 103. The source/drain regions 104 may be exposed at the bottom of the third opening 113.

Referring to FIG. 9, the third opening 113 may be filled with an electrically conductive material, and the electrically conductive material may be planarized to form the contact structures 151. The electrically conductive material forming the contact structures 151 may include one or more materials selected from W, Al, Ag, Cr, Mo, Ni, Pd, Pt, Ti, Ta and Cu, but the present invention is not limited thereto. For example, in the present invention, the electrically conductive material may be Cu, and an electrochemical plating (ECP) method may be applied to fill the third opening 113 with the electrically conductive material.

Because the contact structures 151 and the gate structures 120 are isolated by the capping layer 131 and the sidewall spacer 102 and the capping layer 131 is disposed over the sidewall spacers 102 and extends transversely, any possibly existing gaps between the sidewall spacers 102 and the gate structures 120 maybe covered. Accordingly, the issue regarding a short circuit induced by the electrically conductive material of the contact structures 151 to contact the gate electrode layers 122 via the gaps between the sidewall spacers 102 and the gate electrode layers 122 may be avoided, and performance of semiconductor devices may be improved.

FIG. 10 illustrates an intermediate structure corresponding to another exemplary fabrication process of a semiconductor device consistent with the disclosed embodiments. Referring to FIG. 10, different from the above-described fabrication process, in one embodiment, the thickness of the removed portion of the sidewall spacers 102 may be greater than the thickness of the removed portion of the gate structures 120. That is, the top surface of the sidewall spacers 102 may be lower than the top surface of the gate structures 120.

In one embodiment, the fabrication process to form the sidewall spacers 102, the first dielectric layer 103, the source/drain regions 104, the gate structures 120, the capping layer 131, the second dielectric layer 141, and the contact structures 151 may refer to corresponding descriptions, which are not repeated here.

In one embodiment, the capping layer 131 may still cover possibly existing gaps between the sidewall spacers 102 and the gate structures 120. Thus, the issue of a short circuit induced by the electrically conductive material of the contact structures 151 to contact the gate electrode layers 122 via the gaps between the sidewall spacers 102 and the gate electrode layers 122 may be avoided, and the performance of the semiconductor devices may be improved.

Correspondingly, the present invention also provides a semiconductor device. Referring to FIG. 9, FIG. 9 illustrates a cross-sectional view of an exemplary semiconductor device consistent with disclosed embodiments. The semiconductor device may include a substrate 100, gate structures 120 disposed on the substrate 100, a first dielectric layer 103, sidewall spacers 102 disposed on two sides of each gate structure 120, a capping layer 131, source/drain regions 104, a second dielectric layer 141, and contact structures 151.

The gate structures 120 and the sidewall spacers 102 may be disposed in the first dielectric layer 103, and the top surface of the gate structures 120 and the top surface of the sidewall spacers 102 may be lower than the top surface of the first dielectric layer 103. The capping layer 131 may be disposed on the gate structures 120 and the sidewall spacers 102, and the top surface of the capping layer 131 may level with the top surface of the first dielectric layer 103. The source/drain regions 104 may be located on two sides of each gate structure 120 in the substrate 100. The second dielectric layer 141 maybe disposed on the first dielectric layer 103 and the capping layer 131. The bottom of the contact structures 151 may get in touch with the source/drain regions 104, and walls of the contact structures 151 may get in touch with the sidewall spacers 102, the capping layer 131, and the second dielectric layer 141, respectively.

In some embodiments, the top surface of the sidewall spacers 102 may be higher than the top surface of the gate structures 120. In some other embodiments, the top surface of the sidewall spacers 102 may be lower than or level with the top surface of the gate structures 120. The height of the sidewall spacers 102 may be approximately 50%∼90% of the height of the first dielectric layer 103. The height of the gate structures 120 may be approximately 50%∼80% of the height of the first dielectric layer 103.

In one embodiment, the top surface of the sidewall spacers 102 may be higher than the top surface of the gate structures 120. The height of the sidewall spacers 102 may be approximately 70% of the height of the first dielectric layer 103, and the height of the gate structures 120 may be approximately 50% of the height of the first dielectric layer 103.

The substrate 100 may be a semiconductor substrate, such as a single-crystalline silicon substrate, a single-crystalline germanium substrate, a silicon germanium substrate, a silicon carbide substrate, a silicon-on-insulator substrate, and/or a germanium-on-insulator substrate. The substrate 100 may also be a semiconductor substrate or fins formed on the semiconductor substrate. In one embodiment, the substrate 100 may be a fin formed on the semiconductor substrate.

The material of the sidewall spacers 102 may include a material selected from silicon nitride, silicon oxynitride, and carbon-doped silicon oxynitride, or any combination thereof. In one embodiment, the material of the sidewall spacers 102 may be silicon nitride.

Each gate structure 120 may include a gate dielectric layer 121 and a gate electrode layer 122. In particular, the gate dielectric layer 121 may cover a part of the substrate 100 and side surfaces of the sidewall spacers 102, and the gate electrode layer 122 may be formed over the gate dielectric layer 121.

The material of the gate dielectric layer 121 may be a high-K dielectric material (the dielectric coefficient greater than 3.9). The high-K dielectric material may include hafnium oxide, zirconium oxide, hafnium zirconium oxide, lanthanum oxide, zirconium silicon oxide, titanium oxide, tantalum oxide, barium strontium titanium oxide, barium titanium oxide, strontium titanium oxide, and/or aluminium oxide. In one embodiment, the material of the gate dielectric layer 121 may be hafnium oxide.

The material of the gate electrode layer 122 may be Cu, W, Al, Au, and/or Ag. In one embodiment, the material of the gate electrode layer 122 may be W. Before forming the gate electrode layer 122, an insulation layer may be formed over the surface of the gate dielectric layer 121, and a work function layer may be formed over the surface of the insulation layer. The material of the work function layer may be a metal or a metallic compound.

The material of the capping layer 131 may include silicon nitride, titanium nitride, silicon carbide, silicon oxynitride, carbon-doped silicon oxynitride, silicon oxide, and/or aluminium oxide. In one embodiment, the material of the capping layer 131 may be silicon nitride.

The material of the contact structures 151 may be one or more selected from W, Al, Ag, Cr, Mo, Ni, Pd, Pt, Ti, Td and Cu, but the present invention is not limited thereto. In one embodiment, the material of the contact structures 151 maybe Cu.

Referring to FIG. 10, FIG. 10 illustrates a cross-sectional view of another exemplary semiconductor device consistent with the disclosed embodiments. Different from the above-described semiconductor device, in one embodiment, as shown in FIG. 10, the height of the sidewall spacers 102 may be smaller than the height of the gate structures 120. In one embodiment, the height of the sidewall spacers 102 may be 50% of the height of the first dielectric layer 103, and the height of the gate structures 120 may be 70% of the height of the first dielectric layer 103.

The structures of the gate structures 120, the first dielectric layer 103, the sidewall spacers 102, the capping layer 131, the source/drain regions 104, the second dielectric layer 141 and the contact structures 151 may refer to corresponding descriptions, which are not repeated here.

Accordingly, the fabrication method of the disclosed semiconductor device may include removing a portion of the sidewall spacers and a portion of the gate structures, respectively, after removing the dummy gate structures and forming the gate structures. Further, the fabrication method may include forming a capping layer on the sidewall spacers and the gate structures. Accordingly, the fabricated contact structures may be electrically connected to the source/drain regions and, simultaneously be isolated from the gate structures by the capping layer on the sidewall spacers. Thus, the short circuit issue induced by the electrically conductive material of the contact structure to contact the gate structure may be effectively avoided, and the performance of the semiconductor devices may be improved.

Further, instead of etching and removing a portion of the sidewall spacers before removing the dummy gate structures, according to the disclosed fabrication process, a portion of the sidewall spacers and a portion of the gate structures may be removed after the dummy gate structures are removed and the gate structures are formed. Accordingly, the fabrication of the semiconductor device may be simplified and the whole process may be completed in a gate electrode etching machine.

In the disclosed semiconductor device, because the capping layer is disposed on the sidewall spacers and the gate structures, the contact structures may be electrically connected to the source/drain regions and, simultaneously be isolated from the gate structures by the capping layer. Thus, the issue that the contact structure will contact the gate structure to induce a short circuit may be effectively avoided, and the performance of the semiconductor device may be improved.

## Claims

1. A method for fabricating a semiconductor device, comprising:
forming at least one dummy gate structure and sidewall spacers of the dummy gate structure in a first dielectric layer, together on a substrate;
removing the dummy gate structure, thereby forming a first opening between the sidewall spacers;
forming a gate structure in the first opening and having a top surface levelled with the first dielectric layer;
removing a portion of the sidewall spacers and a portion of the gate structure, respectively, to form a second opening in the first dielectric layer, on remaining sidewall spacers, and on remaining gate structure; and
forming a capping layer to fill the second opening and to have a top surface levelled with the first dielectric layer.

2. The method according to claim 1, wherein:
the dummy gate structure, the sidewall spacers, and the first dielectric layer have a coplanar top surface.

3. The method according to claim 1 or 2, wherein:
a thickness of the removed portion of the sidewall spacers is greater than a thickness of the removed portion of the gate structure; or, alternatively, a thickness of the removed portion of the sidewall spacers is less than or equal to a thickness of the removed portion of the gate structure.

4. The method according to any one of the claims 1-3, wherein:
a thickness of a removed portion of the sidewall spacers ranges from 100 Å to 1000 Å; and/or a thickness of a removed portion of the gate structure ranges from 100 Å to 1000 Å.

5. The method according to any one of the claims 1-4, wherein:
the portion of the sidewall spacers is removed before or after the portion of the gate structure is removed.

6. The method according to any one of the claims 1-5, wherein:
removing the portion of the sidewall spacers includes a dry etching process, and
an etching gas for the dry etching process includes one or more gases selected from CF₃I, O₂, and H₂.

7. The method according to any one of the claims 1-6, wherein forming the gate structure in the first opening comprises:
forming a gate dielectric layer on a surface of the substrate and on the sidewall spacers of the first opening; and
forming a gate electrode layer over the gate dielectric layer to fill the first opening;
wherein preferably removing the portion of the gate structure comprises: using a dry or wet etching process to remove a portion of the gate dielectric layer; and using the dry etching process to remove a portion of the gate electrode layer.

8. The method according to any one of the claims 1-7, wherein:
the capping layer is made of one or more materials selected from silicon nitride, titanium nitride, silicon carbide, silicon oxynitride, and carbon-doped silicon oxynitride.

9. The method according to any one of the claims 1-8, wherein:
the sidewall spacers is made of one or more materials selected from silicon nitride, silicon oxynitride, and carbon-doped silicon oxynitride.

10. The method according to any one of the claims 1-9, further comprising:
forming source/drain regions on sides of the dummy gate electrode in the substrate; and
after forming the capping layer, forming contact structures in the first dielectric layer to electrically connect to the source/drain regions;
wherein preferably the contact structures are formed by: forming a second dielectric layer on the first dielectric layer and the capping layer; forming a third opening in the second dielectric layer and the first dielectric layer to expose the source/drain regions; filling the third opening with an electrically conductive material; and planarizing the electrically conductive material to form the contact structures.

11. A semiconductor device, comprising:
a substrate;
a plurality of gate structures and sidewall spacers of each gate structure disposed in a first dielectric layer, together on the substrate;
a capping layer, disposed on each gate structure and the sidewall spacers and having a top surface levelled with the first dielectric layer;
source/drain regions on sides of the gate structures in the substrate;
a second dielectric layer disposed on the first dielectric layer and the capping layer; and
contact structures formed on the source/drain regions and each having a surface in contact with adjacent sidewall spacers, the capping layer, and the second dielectric layer.

12. The semiconductor device according to claim 11, wherein
a top surface of the sidewall spacers are higher than a top surface of the plurality of gate structures; or, alternatively,
a top surface of the sidewall spacers are lower than or level with a top surface of the plurality of gate structures.

13. The semiconductor device according to claim 11 or 12, wherein:
a height of the sidewall spacers is approximately 50%∼90% of a height of the first dielectric layer; and
a height of the plurality of gate structures is approximately 50%∼80% of the height of the first dielectric layer.

14. The semiconductor device according to any one of the claims 11-13, wherein:
the capping layer is made of one or more materials selected from silicon nitride, titanium nitride, silicon carbide, silicon oxynitride, and carbon-doped silicon oxynitride.

15. The semiconductor device according to any one of the claims 11-14, wherein:
the sidewall spacers is made of one or more materials selected from silicon nitride, silicon oxynitride, and carbon-doped silicon oxynitride.
